# Europäisches Patentamt

# European Patent Office

# Office européen des brevets

(19)

(11) Veröffentlichungsnummer : **0 079 459**
**B1**

(12) ## EUROPÄISCHE PATENTSCHRIFT

(45) Veröffentlichungstag der Patentschrift :
07.05.86

(21) Anmeldenummer : **82109295.4**

(22) Anmeldetag : **07.10.82**

(51) Int. Cl.⁴ : **H 01 L 21/90, H 01 L 21/60**

(54) Verfahren zum Herstellen einer Metallisierung auf einer Halbleitervorrichtung.

(30) Priorität : **13.10.81 DE 3140669**

(43) Veröffentlichungstag der Anmeldung :
**25.05.83 Patentblatt 83/21**

(45) Bekanntmachung des Hinweises auf die Patenterteilung : **07.05.86 Patentblatt 86/19**

(84) Benannte Vertragsstaaten :
**DE FR GB**

(56) Entgegenhaltungen :
**DE-A- 2 740 757**
**US-A- 4 154 874**
**PATENTS ABSTRACTS OF JAPAN, Band 5, Nr. 179(E-82)(851), 17. November 1981**
**MICROELECTRONICS AND RELIABILITY, Band 19, Nr. 4, 1979, Seiten 337-343, Oxford, GB., T.K. GUPTA: "Aluminum alloy as an interconnecting material in the fabrication of integrated circuits"**

(73) Patentinhaber : **Siemens Aktiengesellschaft**
**Berlin und München Wittelsbacherplatz 2**
**D-8000 München 2 (DE)**

(72) Erfinder : **Kinzel, Hermann, Ing.-grad.**
**Nikolaus-Lenau-Strasse 22**
**D-8047 Karlsfeld (DE)**

**Beschreibung**

Gegenstand der Erfindung ist ein Verfahren zum Herstellen von Halbleitervorrichtungen, insbesondere von integrierten Schaltungen, bei dem an der Oberfläche einer den Halbleiterkörper der Halbleitervorrichtung mit Ausnahme von Kontaktstellen bedeckenden, anorganischen Isolierschicht eine Metallisierung durch Aufdampfen oder Aufstäuben aufgebracht und durch lokalisierte Wiederabtragung zu elektrischen Leitbahnen bzw. elektrischen Kontakten weiterverarbeitet wird.

Solche Verfahren werden allgemein bei der Herstellung monolithisch integrierter Schaltungen angewendet. Dabei wird von einem monokristallinen, dotierten Siliciumplättchen ausgegangen, an dessen Oberfläche zunächst eine — insbesondere aus $SiO_2$ bestehende — Isolierschicht durch thermische Oxydation bzw. pyrolytische Abscheidung erzeugt und dann mittels Photolack-Ätztechnik zu einer Dotierungsmaske gestaltet wird. Diese Maske wird dann als Diffusionsmaske bei der Erzeugung der für die integrierte Schaltung erforderlichen Dotierungsstruktur im Halbleiterplättchen verwendet und verbleibt — ggf. nach lokalen Umgestaltungen — zum Schutze der erzeugten pn-Übergänge und als Träger der zu erzeugenden Leitbahnen an der Oberfläche des Halbleiterplättchens. Sie weist dann lediglich zu den einzelnen Kontaktstellen der Oberfläche des Siliciumplättchens führende Kontaktfenster auf.

Die auf der Isolierschicht zu erzeugenden Leitbahnen und die zugehörigen Anschlußelektroden für die externe Beaufschlagung der Schaltung bilden die aus der Metallisierung herzustellenden Bestandteile der Halbleiteranordnung. Sie werden aus der Metallisierung durch Photolack-Ätztechnik in bekannter Weise hergestellt. Als Material für die Metallisierung und damit auch für die Kontaktelektroden an der Halbleiteroberfläche in den Fenstern der Isolierschicht wird in den meisten Fällen Aluminium oder eine Aluminiumlegierung verwendet.

Die Metallisierung entsteht üblicher Weise durch Aufdampfen oder durch Aufstäuben (Aufsputtern) in einem einzigen Prozeß, sofern es sich um eine homogene Metallisierung handelt. Die Stärke der Metallisierung bestimmt gemeinsam mit der durch die Strukturierung der Metallisierung eingestellten Breite der Leitbahnen den stromführenden Querschnitt der Leitbahn. Dieser muß z. B. bei integrierten Leistungsschaltkreisen (z. B. NF-Verstärkern und Spannungsversorgungsschaltungen) erheblich größer als z. B. für digitale Schaltungen eingestellt werden.

Will man die Packungsdichte der integrierten Schaltung im Siliciumplättchen möglichst groß machen, so muß man die Metallisierung mit einer höheren Schichtdicke abscheiden, um mit im Interesse der Ersparnis an Chip-Fläche möglichst schmalen Leitbahnen die bei Leistungs-IC's erforderliche Stromquerschnittsfläche zu erzielen.

(Eine integrierte Schaltung, bei der die Leitbahnen mit zu kleinem Querschnitt ausgestaltet sind, führt zu lokalen Erhitzungen des Halbleiterplättchens durch die überbeanspruchten Leitbahnen, was im Interesse der Betriebssicherheit der integrierten Schaltung nicht zu empfehlen ist.)

Weiter ist zu bemerken, daß die Leitbahnen an den Kontaktöffnungen der Isolierschicht zu den Kontaktstellen der Halbleiteroberfläche über Kanten und Stufen der Isolierschicht geführt werden. Gegebenenfalls kann die Isolierschicht auch aus mehreren übereinander aufgebrachten Teilschichten bestehen, von denen wenigstens die unterste in der Regel aus thermisch erzeugtem $SiO_2$ besteht. Oft ist dann in den Isolierschichten eine Ätzstruktur vorhanden, über welche dann eine Leitbahn von einer Anschlußstelle zur anderen geführt ist. Wenn somit die Leitbahnen sehr schmal und wegen des erforderlichen Querschnitts mit einer großen Höhe herzustellen sind, sind an die Qualität der die Grundlage der Leitbahnen bildenden Metallisierung besondere Anforderungen zu stellen. Erfahrungsgemäß besteht gerade bei derartigen Leitbahnen in erhöhtem Maße die Gefahr einer Rißbildung an den Kanten der Oxydschicht, insbesondere wenn deren Höhe größer als 0,9 μm ist. Andererseits zeigt die Erfahrung, daß sich dickere Metallschichten, z. B. Aluminiumschichten, wesentlich schwieriger als dünnere Metallschichten strukturieren lassen. So zeigen Leitbahnen, welche aus einer mehr als 2 μm starken Schicht aus Aluminium geätzt und diese Schicht durch die sog. Heißaufdampfung aufgebracht ist, muschelförmige Kornausätzungen, die sehr leicht zur Unterbrechung der Leitbahn führen können. Andererseits brechen Leitbahnen, deren Metallschicht bei niedrigen Temperaturen des Substrats durch Aufdampfen bzw. Aufsputtern aufgebracht wurde, an den Kanten der Isolierschicht besonders leicht.

Aufgabe der Erfindung ist es, eine Abhilfe gegen die aufgeführten Störungen zu finden.

Hierzu wird gemäß der Erfindung das eingangs definierte Verfahren so ausgestaltet, daß wenigstens 70 % der Gesamtstärke der aus homogenem Material bestehenden Metallisierung in einem ersten Metallisierungsprozeß und wenigstens 10 % der Gesamtstärke dieser Metallisierung in einem abschließenden zweiten Metallisierungsprozeß aufgebracht wird, und daß dabei die Temperatur der mit der Metallisierung zu versehenden Unterlage bei dem ersten Metallisierungsprozeß höher als beim zweiten Metallisierungsprozeß eingestellt wird.

Die auf diese Weise erhaltene Metallisierung und damit auch die aus ihr erhaltenen Leitbahnen bestehen dann aus zwei an sich materialgleichen Schichten, wobei die untere Schicht bezüglich ihrer inneren Beschaffenheit durch die höhere Substrattemperatur während ihrer Aufbringung bleibend beeinflußt ist, während die äußere Schicht dieser Beeinflussung nicht ausgesetzt war. Die während des zweiten Metallisierungsprozesses gegebenen Bedingungen, die abgesehen von der niedrigeren Substrattemperatur und gegebenenfalls einer niedrigeren Aufwachsrate sich von den Bedingungen des ersten Metallisierungsprozesses nicht unterscheiden, beeinträchtigen erfahrungsgemäß die Eigenschaften der zuerst aufgebrachten Metallisierungsschicht nicht. Somit bleibt auch die durch die höhere Substrattemperatur bedingte größere Stabilität der Leitbahnen an den Knickstellen, also an den Stufen der Oxyd- und Halbleiterunterlage, erhalten.

Andererseits hat es sich gezeigt, daß die beim zweiten Metallisierungsprozeß aufgebrachte obere Teilschicht der Metallisierung zu einer glatten Ätzstruktur führt und die genannten Kornausätzungen vermieden werden.

Die Erfindung hat sich vor allem bei der Herstellung von Leitbahnen aus Aluminium oder einer Aluminiumlegierung bewährt. Dabei wurden z. B. folgende Bedingungen angewendet :

70 % bis 90 % der Gesamtstärke der Metallisierung wird bei einer Temperatur von mindestens 250 °C der zu metallisierenden Unterlage, also des Siliciumplättchens und der auf ihm befindlichen Oxydschicht, aufgebracht, während der Rest nachher bei einer Temperatur von höchstens 150 °C dieser Unterlage im zweiten Metallisierungsprozeß aufgebracht wird.

Weiterhin empfiehlt es sich, den ersten Metallisierungsprozeß mit einer größeren Abscheidegeschwindigkeit und den zweiten Metallisierungsprozeß mit einer geringeren Abscheidegeschwindigkeit durchzuführen. Im Beispielsfall der Verwendung von Aluminium als Metallisierungsmaterial wurde bei der Erprobung der Erfindung im ersten Metallisierungsprozeß eine Kondensationsrate von 5-7 nm · s⁻¹ und im zweiten Metallisierungsprozeß eine Kondensationsrate von nur 2-3 nm · s⁻¹ verwendet. Die genannten Bedingungen haben sich laufend bewährt, gleichgültig, ob die Metallisierung durch Aufdampfen oder durch Aufstäuben (Aufsputtern) vorgenommen wurde.

Schließlich empfiehlt es sich, eine Pause von etwa 10 bis 20 Minuten zwischen den beiden Phasen des erfindungsgemäßen Verfahrens vorzusehen, damit das Substrat ausreichend Gelegenheit hat, sich auf die niedrigere Temperatur des zweiten Metallisierungsprozesses einzustellen.

Da Aluminium das am meisten bei der Herstellung von integrierten Schaltungen verwendete Kontaktierungsmaterial ist, wurden die zu der Erfindung führenden Ergebnisse bei Aluminiummetallisierungen gewonnen. Andere Kontaktierungsmetalle, wie z. B. Ti, Ni, Cr, werden bei integrierten Schaltungen nur selten allein eingesetzt. Es ist jedoch auch dann zu erwarten, daß ein der Erfindung entsprechendes Zweiphasenverfahren eine Erhöhung der Stabilität solcher Leitbahnen mit sich bringt.

**Patentansprüche**

1. Verfahren zum Herstellen von Halbleitervorrichtungen, insbesondere von integrierten Schaltungen, bei dem an der Oberfläche einer den Halbleiterkörper der Halbleitervorrichtung mit Ausnahme von Kontaktstellen bedeckenden, anorganischen Isolierschicht eine Metallisierung durch Aufdampfen oder Aufstäuben aufgebracht und durch lokalisierte Wiederabtragung zu elektrischen Leitbahnen bzw. elektrischen Kontakten weiterverarbeitet wird, dadurch gekennzeichnet, daß wenigstens 70 % der Gesamtstärke der aus homogenem Material bestehenden Metallisierung in einem ersten Metallisierungsprozeß und wenigstens 10 % der Gesamtstärke dieser Metallisierung in einem abschließenden zweiten Metallisierungsprozeß aufgebracht wird, und daß dabei die Temperatur der mit der Metallisierung zu versehenden Unterlage bei dem ersten Metallisierungsprozeß höher als beim zweiten Metallisierungsprozeß eingestellt wird.

2. Verfahren nach Anspruch 1, dadurch gekennzeichnet, daß die Abscheidegeschwindigkeit während - des ersten Metallisierungsprozesses größer als während des zweiten Metallisierungsprozesses eingestellt wird.

3. Verfahren nach Anspruch 1 oder 2, dadurch gekennzeichnet, daß eine Metallisierung aus Aluminium verwendet und dabei die Temperatur der zu metallisierenden Unterlage während des ersten Metallisierungsprozesses auf wenigstens 250 °C und während des zweiten Metallisierungsprozesses auf höchstens 150 °C gehalten wird.

4. Verfahren nach Anspruch 2 und 3, dadurch gekennzeichnet, daß die Abscheidungsquote im ersten Metallisierungsprozeß auf 5-7 nm/sec und im zweiten Metallisierungsprozeß auf 2-3 nm/sec eingestellt ist.

**Claims**

1. A method of producing semiconductor devices, in particular integrated circuits, in which a metallisation is applied by vapour deposition or spraying to the surface of an inorganic insulating layer which covers the semiconductor body of the semiconductor device with the exception of contact positions, said metallisation being further processed by localised erosion to form electrical conductor paths and electrical contacts, characterised in that at least 70 % of the total thickness of the metallisation, which consists of a homogeneous material, is applied in a first metallisation process and at least 10 % of the total thickness of the metallisation is applied in a following second metallisation process ; and that the temperature of the substrate which is to be provided with the metallisation is set to be higher in the case of the first metallisation process than in the case of the second metallisation process.

2. A method as claimed in Claim 1, characterised in that the deposition speed is set to be higher in the case of the first metallisation process than in the case of the second metallisation process.

3. A method as claimed in Claim 1 or Claim 2, characterised in that a metallisation of aluminium is used, and the temperature of the substrate which is to be metallised is maintained at a minimum of 250 °C during the first metallisation process and at a maximum of 150 °C during the second metallisation process.

4. A method as claimed in Claim 2 and 3, characterised in that the deposition rate is set at 5-7 nm/sec during the first metallisation process and at 2-3 nm/sec during the second metallisation process.

## Revendications

1. Procédé pour fabriquer des dispositifs à semi-conducteurs, en particulier des circuits intégrés, selon lequel on applique une métallisation par vaporisation ou pulvérisation sur la surface d'une couche isolante inorganique qui recouvre le corps semi-conducteur du dispositif à semi-conducteurs, à l'exception de points de contact, et on la transforme par enlèvement localisé en pistes conductrices ou en contacts électriques, caractérisé en ce que l'on applique au moins 70 % de l'épaisseur totale de la métallisation, constituée d'un matériau homogène, dans un premier processus de métallisation et au moins 10 % de l'épaisseur totale de cette métallisation dans un second processus terminal de métallisation et que l'on règle la température du support à doter de la métallisation à une valeur plus élevée au premier qu'au second processus de métallisation.

2. Procédé selon la revendication 1, caractérisé en ce que l'on règle la vitesse de dépôt pendant le premier processus de métallisation à une valeur plus élevée que pendant le second processus de métallisation.

3. Procédé selon la revendication 1 ou 2, caractérisé en ce que l'on utilise une métallisation à l'aluminium et on maintient la température du support à métalliser à au moins 250 °C pendant le premier processus de métallisation et à tout au plus 150 °C pendant le second processus de métallisation.

4. Procédé selon les revendications 2 et 3, caractérisé en ce que l'on règle le taux de dépôt dans le premier processus de métallisation à 5-7 nm/s et dans le second processus de métallisation à 2-3 nm/s.